# EUROPÄISCHE PATENTANMELDUNG

(11) **EP 1 901 351 A1**
(43) Veröffentlichungstag der Anmeldung: **19.03.2008**
(21) Anmeldenummer: 07024197.1
(22) Anmeldetag: 16.11.2006
(51) Int. Cl.: H01L 23/36, B23K 35/26

(54) **Wärmeleitfolie und Verfahren zur Herstellung einer Wärmeleitschicht**

(30) Priorität: 29.04.2006 DE 102006020584
(62) Teilanmeldung aus: 06023843.3
(71) Anmelder: Metzke, Michael, 39179 Ebendorf (DE)
(72) Erfinder: Metzke, Michael, 39179 Ebendorf (DE); Heyer, Stefan, 39120 Magdeburg (DE)
(74) Vertreter: Kagelmann, Manfred

(57) **Zusammenfassung**

Die Erfindung betrifft eine niedrigschmelzende metallische Wärmeleitfolie und ein Verfahren zu deren Anwendung. Durch das während der Anwendung stattfindende zumindest teilweise Schmelzen der Wärmeleitfolie, wird eine optimale Anpassung an die Oberflächen gewährleistet, zwischen denen der Wärmeübergang hergestellt werden soll. Die erfindungsgemäße Wärmeleitfolie enthält als Hauptbestandteil oder ausschließlich eine zwischen 20°C und 100°C schmelzende metallische Legierung. In diese können unlegierte metallische Bestandteile suspendiert oder anderweitig in Kontakt gebracht sein. Durch Legierungsbildung zwischen diesen Komponenten während der Anwendung kann sich der Schmelzpunkt der entstehenden Wärmeleitschicht erhöhen.

Die Anwendung der erfindungsgemäßen Wärmeleitfolie und des erfindungsgemäßen Verfahrens zu deren Anwendung erfolgt insbesondere in der Elektro- und Elektronikindustrie.

Die Vorzüge der Erfindung bestehen darin, dass die mittels der erfindungsgemäßen Wärmeleitfolie hergestellten Wärmeleitschichten auf eine für die in Kontakt kommenden Bauelemente thermisch schonende Weise hergestellt werden können. Die erfindungsgemäße Wärmeleitfolie besteht ausschließlich aus sehr gut wärmeleitenden Metallen. Durch die während der Anwendung zumindest teilweise Verflüssigung der Wärmeleitfolie werden die Wärmeleitung behindernde isolierende Lufteinschlüsse weitgehend vermieden. Die erfindungsgemäße Wärmeleitfolie kann, im Gegensatz zu den, dem Stand der Technik entsprechenden metallischen Wärmeleitpasten mit hohem Gallium Anteil, auch auf Aluminium angewendet werden.

Mit der Wärmeleitfolie können in ihr unlegierte metallische Stoffe suspendiert oder anderweitig in Kontakt gebracht sein.

Durch die nach der Verflüssigung stattfindende Legierungsbildung zwischen der niedrigschmelzenden metallischen Legierung und den bis dahin unlegierten Komponenten, ändern sich die physikalischen und/oder chemische Eigenschaften der entstehenden Wärmeleitschicht. Der Schmelzpunkt erhöht sich, die thermische und mechanische Belastbarkeit der Wärmeleitschicht wird erhöht.

Die erfindungsgemäße metallische Wärmeleitfolie lässt sich durch die Auswahl ihrer Legierungsbestandteile genau definiert den erforderlichen und gewünschten unterschiedlichen Schmelztemperaturen für unterschiedlichen Anwendungszwecke anpassen (bis 100°C). Der unterschiedlichen thermischen Belastbarkeit elektrischer und elektronischer Bauelemente kann Rechnung getragen werden. Das hat eine hohe Anwendungssicherheit zur Folge. Die Anwendung des Verfahrens erfordert auch keine überhöhten Pressdrücke bei der Zusammenführung der Bauelemente mit dem Kühlkörper.

## Beschreibung

Die Erfindung betrifft eine metallische Wärmeleitfolie und deren Anwendung. Die Anwendung ist auf die Herstellung einer Wärmeleitschicht gerichtet.
Diese Wärmeleitfolie besteht ganz oder in ihrem Hauptbestandteil aus einer zu einer Folie ausgewalzten metallischen Legierung, deren Schmelzpunkt zwischen 20° Celsius und 100° Celsius liegt.
In diese metallische Legierung können zur Optimierung der Eigenschaften andere Metalle oder metallische Legierungen suspendiert oder mit ihr in Kontakt gebracht sein.
Geeignet sind dieser Stoff und das Verfahren insbesondere zur Verwendung in der Elektro- und
Elektronikindustrie, aber auch zur Kühlung thermisch hoch belasteter mechanischer Bauteile, z.B. in Motoren.

Bekannt ist, dass gewisse elektrische und/oder elektronische Bauelemente im Betrieb Verlustwarme entwickeln. Diese wird über geeignete Kühlkörper oder Kühlvorrichtungen abgeführt. Der Kontakt dieser Kühlkörper oder Kühlvorrichtungen zum zu kühlenden Bauelement wird dabei mittels Verwendung von Wärmeleitpasten oder Wärmeleitfolien hergestellt.

Diese haben die Aufgabe, an den Kontaktflächen entstehende, den Wärmeübergang behindernde Lufteinschlüsse zu vermeiden oder zu verringern.

Diese Wärmeleitpasten oder Wärmeleitfolien müssen in der Hauptsache folgenden Anforderungen entsprechen:
a)möglichst guter Wärmeleitwert
b)flüssige oder pastöse Konsistenz, zur optimalen Anpassung an die Oberflächen von zu kühlendem elektrischen/elektronischen Bauelement und der Kontaktflache des Kühlers bzw. der Kühlvorrichtung.
c)Chemische und physikalische Verträglichkeit der verwendeten Substanzen mit den Flächen auf denen sie aufgetragen werden (möglichst keine Wechselwirkungen wie chemische Reaktionen oder unerwünschte Legierungsbildung)
d)Toxikologische Unbedenklichkeit.

Als Wärmeleitmittel sind bekannt, als Wärmeleitpasten verwendete Pasten bestehend aus einem Matrixmaterial und einem Pulver, welches im Matrixmaterial verteilt ist und von diesem umschlossen wird.

Das Matrixmaterial besteht aus Silikon oder einem anderen nichtmetallischen Stoff, als Pulver werden Metalle, Kohlenstoff (Graphit) oder Metalloxide verwendet.
Da in diesen Wärmeleitpasten nichtmetallische Stoffe als Matrix und /oder als suspendiertes Material verwendet werden, die die Wärme schlecht leiten, besitzen diese "Wärmeleitpasten" einen relativ geringen Wärmeleitwert von etwa 0,5 W/mK bis nicht mehr als 10 W/mK.

Bekannt sind als Wärmeleitmaterialien auch metallische Matrixmaterialien aus Gallium oder Legierungen des Galliums, insbesondere mit Indium, Zinn und Zink. In dieses metallische Matrixmaterial können andere gut wärmeleitende und sich mit dem Matrixmaterial nicht legierende Stoffe wie z.B. Metallpulver und/oder Kohlenstoff suspendiert sein.

Nachteilig an diesen Wärmeleitpasten ist, dass sie sich in flüssigem Aggregatzustand sehr stark korrosiv insbesondere gegen Leichtmetalle verhalten. Insbesondere mit Aluminium legieren sie sich sehr leicht, wobei die entstehende Gallium - Aluminium Legierung sich unter dem Einfluss der Luftfeuchtigkeit chemisch zersetzt. Die Zersetzungsprodukte wiederum können mit anderen Materialien reagieren.

Der bei der Zersetzung entstehende Wasserstoff kann im Falle seiner Anreicherung zur Bildung von entzündlichen Wasserstoff - Luft Gemischen beitragen (EP 044 268 A1. Zum Auftrag auf das in der Technik sehr häufig verwendete Aluminium sind diese Pasten daher gänzlich ungeeignet.

Bekannt sind weiterhin Wärmeleitfolien in Form von Wärmeleitpads aus thermoplastischer Folie mit einem geringen Wärmeleitwert von nicht mehr als 10 W/mK.

Bekannt sind auch Wärmeleitfolien aus Metallen wie Kupfer, Silber oder Gold. Diese Metalle besitzen zwar hohe Wärmeleitwerte, sind aber zu hart um sich den Oberflächen der Materialien optimal anzupassen, zwischen denen die Wärmeleitung hergestellt werden soll.
Bei Verwendung dieser Folien kommt es durch mikroskopisch kleine Unebenheiten (Oberflächenrauhigkeit) zur Ausbildung von isolierend wirkenden Lufteinschlüssen sowohl auf der einen, wie auch auf der anderen Seite der Folie. Die mit diesen Folien zu erzielenden Resultate sind daher in der Regel schlechter als bei einem völligen Verzicht auf ein Wärmeleitmittel (da zwei anstatt einem isolierendem Luftpolster).

Bekannt sind auch Wärmeleitfolien aus Indium. Dieses relativ weiche Metall muss zur Vermeidung des vorstehend beschriebenen Effektes (Lufteinschlüsse) mit einem hohen Druck zwischen zu kühlendes Bauelement und Kühler gepresst werden.
Das erfordert einen hohen technologischen Aufwand. Auch sind viele elektrische und/oder elektronische Bauelemente für eine solche Druckbeaufschlagung nicht geeignet.

Aufgabe der Erfindung ist es, einen geeigneten Stoff und ein geeignetes Verfahren zur Realisierung einer Wärmeleitverbindung zwischen elektrischen und/oder elektronischen und/oder mechanischen Bauelementen und/oder Baugruppen zu schaffen, die die Nachteile bisher bekannter Stoffe und Verfahren vermeidet.

Erfindungsgemäß wird die Aufgabe, wie mit den Ansprüchen angegeben, gelöst.

Die Wärmeleitschicht zur Anordnung zwischen elektrischen und/oder elektronischen und/oder mechanischen Bauelementen und/oder Baugruppen einerseits und Kühlkörpern und/oder Kühlelementen andererseits wird hergestellt durch Anwendung einer metallischen Wärmeleitfolie, bestehend aus einer metallischen Legierung, die zu einer Folie ausgewalzt wird und die einen Schmelzpunkt zwischen 20°C und 100°C zwischen hat. Mit dieser metallischen Legierung können zur Optimierung der Eigenschaften andere Metalle suspendiert oder anderweitig in Kontakt gebracht worden sein, deren Schmelzpunkt oberhalb des Schmelzpunktes der metallischen Legierung liegt. Zur Herstellung der niedrigschmelzenden metallischen Wärmeleitfolie wird eine niedrigschmelzende metallische Legierung verwendet, die insbesondere die Metalle Indium, Wismut, Zinn und Gallium in unterschiedlichen qualitativen wie quantitativen Zusammensetzungen enthalten kann. Nicht verwendet werden Metalle, die aufgrund ihrer toxikologischen Eigenschaften gesetzlichen Einschränkungen und/oder Verboten unterliegen, wie z.B. Cadmium, Blei, Quecksilber usw.
Mit dieser zu einer Folie ausgewalzten niedrigschmelzenden metallischen Legierung können andere Metalle in Kontakt gebracht sein oder werden (z.B. durch Suspendierung oder zusätzliche Schicht in einer mehrlagigen Folie).

Zur Anwendung kommen dabei
a)Metalle die sich mit der niedrigschmelzenden metallischen Legierung auch nach deren Erwärmung auf eine Temperatur oberhalb ihres Schmelzpunktes nicht oder nur geringfügig legieren (wie z.B. Molybdän, Wolfram, Nickel und andere). Geeignet ist auch das Nichtmetall Kohlenstoff.
b)Metalle, die sich mit der niedrigschmelzenden metallischen Legierung legieren. Das geschieht im Verlauf der Anwendung, nach deren Erwärmung auf eine Temperatur oberhalb des Schmelzpunktes der niedrigschmelzenden Legierung. Das können Metalle sein, die in der niedrigschmelzenden metallischen Legierung schon vorhanden sind (z.B. Suspension von Indium in einer Legierung bestehend aus Indium/Wismut und Zinn). Oder es sind Metalle, die in der niedrigschmelzenden metallischen Legierung noch nicht vorhanden sind (z.B. Suspension von Kupfer in einer Legierung bestehend aus Indium/Wismut und Zinn).
   Durch das zusätzliche Einlegieren von Metallen in die niedrigschmelzende Metalllegierung entsteht eine neue Metalllegierung mit neuen physikalischchemischen Eigenschaften.

Der Schmelzpunkt der neu entstandenen Legierung liegt in der Regel höher als der Schmelzpunkt der zuvor verwendeten niedrigschmelzenden Metalllegierung.
Mit der Legierungsbildung steigt der Schmelzpunkt, das Material härtet aus.
Die Legierungsbildung und das damit verbundene Ansteigen des Schmelzpunktes der Legierung (Aushärtung), ist erst während und nach der Anwendung der Wärmeleitfolie erwünscht.

So wird sichergestellt, das sich die niedrigschmelzende Wärmeleitfolie nach nur geringer Erwärmung durch Übergang aus dem festen in eine flüssige bzw. pastöse Form den Oberflächen, auf die sie aufgetragen wird, optimal anpasst.

Angewendet wir die Erfindung indem zur Herstellung der Wärmeleitschicht zwischen elektrischen und/oder elektronischen und/oder mechanischen Bauelementen und/oder Baugruppen und Kühlkörpern und/oder Kühlelementen wird zunächst die Wärmeleitfolie ungeschmolzen auf eine oder beide Flächen, zwischen denen der Wärmeübergang stattfinden soll, aufgelegt.
Anschließend werden diese Flächen zusammengeführt.

Kurz vor, während oder nach dem Zusammenführen dieser Flächen wird durch externe Erwärmung die Wärmeleitfolie ganz oder teilweise geschmolzen. Die externe Wärmezufuhr kann über einen gezielten Heißluftstrom, durch ein Heißluftbad z.B. in einem Wärmetunnel oder durch eine direkte Berührung des Kühlkörpers mit einem beheizten Passstück erfolgen. Ergänzend oder alternativ zur externen Wärmezufuhr kann durch Inbetriebnahme des zu kühlenden Bauelementes oder der zu kühlenden Baugruppe Verlustwärme erzeugt werden, die die Wärmeleitfolie ganz oder teilweise zur Schmelze bringt.

Die Vorzüge der Erfindung bestehen darin, dass mittels der erfindungsgemäßen Wärmeleitfolie eine optimale Wärmeleitung zwischen den Bauelementen und/oder Baugruppen hergestellt werden kann, zwischen denen sich die Folie befindet. Die Wärmeleitfolie besteht ausschließlich aus sehr gut wärmeleitenden Materialien. Die erfindungsgemäß hergestellte Wärmeleitfolie ist während der Anwendung zumindest zeitweilig flüssig oder pastös. So kann sie sich den Flächen, zwischen denen der Wärmetransport stattfinden soll, optimal anpassen. Den Wärmeübergang behindernde, isolierend wirkende Lufteinschlüsse, werden so weitgehend vermieden.

Da die Folie schon bei geringen Temperaturen ganz oder teilweise schmilzt, kann der Wärmeleitkontakt zwischen Bauelemente und/oder Baugruppen auf eine thermisch schonende Weise hergestellt werden.
Die Wärmeleitfolie besteht aus einer niedrigschmelzenden Metalllegierung, in der andere Metalle suspendiert oder anderweitig in Kontakt gebracht sein können. Wenn sich diese Metalle während der Anwendung der Folie mit der niedrigschmelzenden Metalllegierung legieren, dann erhöht sich der Schmelzpunkt der entstehenden Wärmeleitschicht, was zu einer hohen thermischen Belastbarkeit führt.
Eine erfindungsgemäß derart hergestellte Wärmeleitschicht hat aufgrund der durch Legierungsbildung erfolgenden Aushärtung, im Vergleich zu dauerhaft flüssigen, oder durch die Verlustwarme der Bauelemente immer wieder Aufschmelzenden metallischen Wärmeleitschichten, eine höhere Resistenz gegen den oxydativen Einfluss des Luftsauerstoffes und damit eine längere Haltbarkeit.

Die Eigenschaften der erfindungsgemäßen Wärmeleitfolie lassen sich durch die Auswahl der in ihr legierten Bestandteile genau definiert den erforderlichen und gewünschten unterschiedlichen Schmelztemperaturen für unterschiedliche Anwendungszwecke anpassen. Aufgrund des sehr niedrigen Schmelzpunktes der verwendeten Legierungen werden keine hohen Ansprüche an die Thermische Belastbarkeit der zu kühlenden Bauelemente gestellt, was eine hohe Anwendungssicherheit zur Folge hat.
Die Anwendung des Verfahrens erfordert auch keine überhöhten Pressdrücke bei der Zusammenführung der Bauelemente mit dem Kühlkörper.
Erfindungsgemäß werden auch keine Metalle oder andere Stoffe verwendet, die Aufgrund ihrer toxischen Eigenschaften gesetzlichen Einschränkungen oder Verboten unterliegen, so dass die Anwendung diesbezüglich keinerlei Beschränkungen unterliegt.

Nachstehend wird die Erfindung an vier Ausführungsbeispielen erläutert.

### Beispiel 1

Magnesiumpulver wird in eine flüssige, niedrigschmelzende metallische Legierung, bestehend aus Indium, Wismut und Zinn, eingerührt.
Die so entstehende Suspension von Magnesium in einer Indium/Wismut/Zinn Legierung wird schnell abgekühlt und so noch vor der Legierungsbildung mit dem Magnesium verfestigt.

Die metallische Legierung mit dem darin suspendierten Magnesium wird zu einer Folie ausgewalzt.

Im Verlauf der Anwendung schmilzt die in der Folie enthaltene niedrigschmelzende
Indium, Wismut, Zinn Legierung durch' die Verlustwärme des zu kühlenden Bauelementes. Das ungeschmolzene Magnesium legiert sich mit der Indium, Wismut, Zinn Legierung. Der Schmelzpunkt der neu entstandenen Indium, Wismut,
Zinn, Magnesium Legierung ist höher als der Schmelzpunkt der Indium, Wismut, Zinn Legierung. Das Material härtet dauerhaft aus.

### Beispiel 2

Die erste Schicht einer Folie, die aus zwei oder mehreren Schichten besteht, besteht aus einer bei 59°C schmelzenden metallischen Legierung, bestehend aus Indium/Wismut und Zinn. In dieser Legierung können sich nicht legierende andere Stoffe, vorzugsweise gut wärmeleitfähige Stoffe, suspendiert sein.
Die zweite Schicht der Folie besteht aus Magnesium. Erst bei länger andauernder Erwärmung über 59°C hinaus kommt es zu einer irreversiblen Reaktion zwischen den Schichten (Legierungsbildung). Der Schmelzpunkt steigt, das Material härtet aus.

### Beispiel 3

Eine Folie besteht aus einer bei 59°C schmelzenden metallischen Legierung, bestehend aus Indium, Wismut und Zinn. In dieser Legierung können sich nicht legierende andere Stoffe, vorzugsweise gut wärmeleitfähige Stoffe, suspendiert sein. Diese Folie wird auf die aus Magnesium bestehende Kontaktfläche eines Kühlkörper gelegt und durch externe Wärmezufuhr und/oder durch die Verlustwärme des zu kühlenden Bauelementes geschmolzen. Es kommt zur oberflächlichen Legierungsbildung mit dem Magnesium der Kontaktfläche, die Wärmeleitschicht härtet aus.

### Beispiel 4

Eine erfindungsgemäß gefertigte Wärmeleitfolie wird zwischen die Oberflächen gelegt, zwischen denen der Wärmetransport erfolgen soll. Die Oberflächen werden zusammengedrückt. Bis dahin konnte sich die noch feste Folie den Oberflachen, zwischen denen sie liegt und zwischen denen der Wärmetransport erfolgen soll, noch nicht optimal anpassen. Bei erstmaliger Inbetriebnahme des aus den Bauelementen zusammengefügten Bauteiles steigt die Temperatur des zu kühlenden Bauelementes durch Abgabe der Betriebswärme(Verlustwärme) auf einen Wert, der über der Schmelztemperatur der in der erfindungsgemäßen Wärmeleitfolie enthaltenen niedrigschmelzenden Metalllegierung liegt. Diese schmilzt sodann und die Schmelze passt sich den Oberflächen optimal an.

## Patentansprüche

1. Metallische Wärmeleitfolie und Verfahren zu deren Anwendung, **dadurch gekennzeichnet, dass**
der alleinige oder der Hauptbestandteil dieser Folie eine metallische Legierung ist, deren Schmelzpunkt zwischen 20°C und 100°C liegt und dass
in dieser zu einer Folie ausgewalzten niedrigschmelzenden metallischen Legierung andere Metalle suspendiert und/oder mit dieser anderweitig in Kontakt gebracht sind oder in Kontakt gebracht sein können
und/oder dass
die metallische Wärmeleitfolie aus einer oder mehreren Schichten besteht, wobei zumindest eine dieser Schichten ganz oder teilweise aus einer niedrigschmelzenden metallischen Legierung besteht, deren Schmelzpunkt zwischen 20°C und 100°C liegt und/oder dass
die sich in der so hergestellten metallischen Wärmeleitfolie befindende niedrigschmelzende metallische Legierung während der Anwendung schmelzbar ist und das Schmelzen durch
Zuführung externer Wärme und/oder durch die Verlustwärme der in Kontakt gebrachten elektrischen und/oder elektronischen Bauelemente und/oder Baugruppen erfolgt
Und/oder dass
durch das zumindest zeitweilige ganz oder teilweise Schmelzen der metallischen Wärmeleitfolie eine optimale Anpassung an die Oberflächen erfolgen kann, zwischen denen die Wärmeleitung hergestellt werden soll
und dass
sich nach dem Schmelzen der in der metallischen Wärmeleitfolie enthaltenen niedrigschmelzenden Metalllegierung, andere darin suspendierte oder anders in Kontakt gebrachte Metalle mit dieser Legierung legieren, wobei eine neue Legierung entsteht, die eine qualitativ und/oder quantitativ andere Zusammensetzung hat als die ursprüngliche Legierung, und die damit über andere physikalische und/oder chemische Eigenschaften verfügt und dass
als alleiniger oder Hauptbestandteil der metallischen Wärmeleitfolie alle metallischen Legierungen mit einem Schmelzpunkt zwischen 20°C und 100°C verwendet werden können, was unter anderen für binäre, ternäre und andere Legierungen der Metalle Gallium, Indium, Wismut und Zinn gilt
und/oder dass
mit der zwischen 20°C und 100°C schmelzenden metallischen Legierung Metalle suspendiert oder anderweitig in Kontakt gebracht sind oder sein können, die sich nach dem Schmelzen dieser zwischen 20°C und 100°C schmelzenden Legierung mit dieser legieren und so die qualitative und/oder quantitative Zusammensetzung dieser Legierung verändern, wobei dieser Vorgang während der Anwendung der Wärmeleitfolie erfolgt
und/oder dass
mit der zwischen 20°C und 100°C schmelzenden metallischen Legierung Metalle suspendiert oder anderweitig in Kontakt gebracht sind oder sein können, die sich mit dieser zwischen 20°C und 100°C schmelzenden Legierung nicht legieren und so die qualitative und/oder quantitative Zusammensetzung dieser Legierung nicht verändern,
wobei diese unlegierten Bestandteile eine pastöse Konsistenz der Schmelze bewirken, welche nach dem Schmelzen der ganz oder in ihrem Hauptbestandteil aus einer niedrigschmelzenden Legierung bestehenden Wärmeleitfolie entsteht
und/oder dass
das mit der erfindungsgemäßen Wärmeleitfolie zum Zweck der Legierungsbildung während der Anwendung in Kontakt gebrachte einzulegierende Metall Bestandteil des elektronischen Bauelementes oder der Baugruppe ist oder sein kann, auf die die Wärmeleitfolie aufgetragen wird, wobei sich diese mit dem Metall an der in Kontakt gebrachten Oberfläche des Bauelementes, auf die die metallische Wärmeleitfolie aufgetragen wird legiert und die so entstandene Wärmeleitschicht einen höheren Schmelzpunkt als die niedrigschmelzende Metalllegierung, die alleiniger oder Hauptbestandteil der erfindungsgemäßen Wärmeleitfolie ist, hat.
